# FASCICULE DE BREVET EUROPEEN

(11) **EP 1 951 610 B1**
(45) Date de publication et mention de la délivrance du brevet: **12.10.2011**
(21) Numéro de dépôt: 06831096.0
(22) Date de dépôt: 09.11.2006
(51) Int. Cl.: B81C 1/00

(54) **PROCEDE DE FORMATION DE MOULES POUR NANO-IMPRESSION**
VERFAHREN ZUM BILDEN VON FORMEN FÜR DAS NANOPRÄGEN
METHOD OF FORMING MOULDS FOR NANO IMPRINTING

(30) Priorité: 09.11.2005 FR 0511401
(43) Date de publication de la demande: 06.08.2008
(73) Titulaire: Commissariat à l'Énergie Atomique et aux Énergies Alternatives, 75015 Paris (FR)
(72) Inventeur: LANDIS, Stephan, F-38500 Voiron (FR); GOUY, Jean-Philippe, F-38950 Quaix en Chartreuse (FR)
(74) Mandataire: Quantin, Bruno Marie Henri
(86) Numéro de dépôt international: PCT/FR2006/002496
(87) Numéro de publication internationale: WO 2007/054643

(56) Documents cités:
- FR-A- 2 869 601
- US-A1- 2005 100 828
- JOHNSON S ET AL: "Fabrication of multi-tiered structures on step and flash imprint lithography templates" MICROELECTRONIC ENGINEERING, vol. 67-68, juin 2003 (2003-06), pages 221-228, XP004428873 ELSEVIER PUBLISHERS BV., AMSTERDAM, NL ISSN: 0167-9317

## Description

### Domaine technique de l'invention

Cette invention traite d'un procédé permettant de réaliser un support comportant un ou plusieurs motifs 3D. Ce support que l'on utilise couramment comme masque pourra être, en fonction des matériaux choisis, transparent à la lumière visible et/ou aux ultraviolets, par exemple. Le support de l'invention peut ainsi être utilisé comme moule pour réaliser des motifs par nano-impression ; dans ce cas, le matériau choisi n'est en pratique pas transparent. Ce procédé concerne principalement, soit la lithographie par nano-impression, soit la lithographie interférométrique optique et, par exemple, à rayons UV profonds (de longueur d'onde inférieure à 248 nanomètres). Ce procédé peut également être utilisé pour la fabrication de masques optiques à décalage de phase pour la lithographie optique.

### Etat de l'art

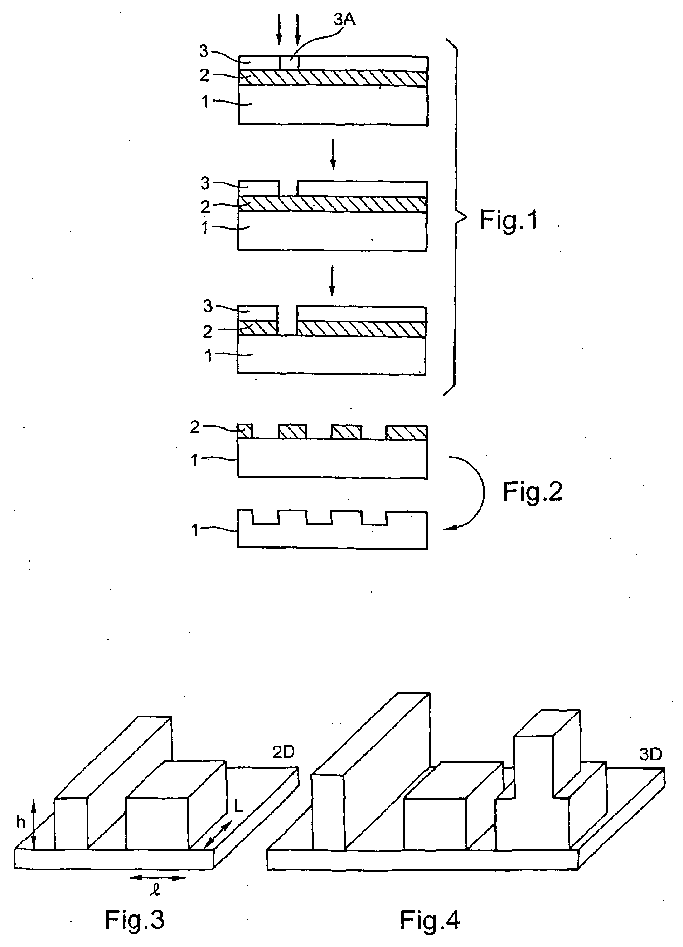

Le procédé standard de fabrication de masques transparents pouvant être utilisés pour la lithographie par nano impression (dans la configuration « step and flash ») ou pour la lithographie optique est décrit par la figure 1.

Sur un support transparent 1, avantageusement du quartz lorsque le masque est destiné à travailler à des longueurs d'ondes supérieures à 193 nm, une couche métallique 2, de chrome par exemple, est dans un premier temps déposée. Cette couche métallique permet de supprimer localement la transparence du support et, par ailleurs, permet de s'affranchir des effets de charges lors des étapes de lithographie électronique nécessaires pour définir les motifs que l'on veut réaliser. Un film de résine photosensible 3 est par la suite utilisé pour définir des motifs qui seront transférés dans la couche métallique. Plus précisément, un rayonnement (flèches verticales) est utilisé au travers d'un masque en sorte de n'atteindre qu'une partie 3A de cette couche ; un traitement de développement permet alors d'éliminer uniquement les portions du film de résine positive photosensible qui ont été illuminées. Un traitement d'attaque sélective est alors effectué au travers des espaces 3A, tandis que les zones recouvertes par la résine 3 restent intactes. On obtient ainsi un support transparent comportant des zones réfléchissantes (là où subsiste la couche métallique) et des zones transparentes (là où la couche métallique a pu être éliminée par l'attaque sélective précitée.

Dans le cas où il est nécessaire d'avoir un masque totalement transparent mais présentant une topographie, le procédé précédemment décrit peut être utilisé en transférant dans le matériau transparent les motifs dans la couche métallique ; la figure 2 montre ainsi que l'on peut obtenir, par attaque de la couche 1 à travers le masque constitué par la couche 2, un transfert dans cette couche 1 des motifs de la couche 2 (ceux-ci ayant été, en pratique, réalisés par la technique décrite à la figure 1) ; il suffit ensuite, pour obtenir le masque souhaité, d'éliminer la couche 2 (celle-ci n'a pas besoin d'être métallique comme dans la figure 1 puisqu'elle est destinée à être éliminée avant utilisation du masque). Mais cette technique impose de maîtriser la gravure du quartz, par exemple avec un masque de chrome. Ce procédé est bien connu pour des motifs dont les dimensions sont de plusieurs centaines de nanomètres. Cependant, la mise ne oeuvre d'un tel procédé pour des dimensions inférieures à 100 nm est beaucoup plus problématique.

Par ailleurs, le procédé décrit, et donc les techniques classiques de microtechnologie ou de nanotechnologie, ne permettent pas de réaliser simplement des motifs en trois dimensions, c'est-à-dire avec une hauteur différente de motif à motif.

La comparaison des figures 3 et 4 permet de percevoir les notions respectives de motifs 2D et de motifs 3D ; à la figure 3, les deux motifs représentés ont des dimensions L et I différentes parallèlement au support mais ces motifs ont des hauteurs égales ; on dit que ces motifs sont de type 2D. Par contre, à la figure 4, les trois motifs présentent des différences en hauteur puisque le motif de gauche est plus haut que celui du milieu mais est moins haut que celui de droite ; en outre, ce motif de droite présente lui-même des différences de hauteur puisqu'il présente des plateaux latéraux (ici de même hauteur que le motif du milieu) ; on dit que ces motifs sont de type 3D.

On comprend aisément que des supports comportant des structures 2D, c'est-à-dire avec des paramètres L ou I différents d'un motif à l'autre, mais avec une hauteur h identique, peuvent être aisément réalisées, par utilisation des procédés classiques de lithographie et gravure schématisés aux figures 1 et 2. Il n'est pas impossible, avec ces mêmes procédés, de fabriquer des structures 3D (c'est-à-dire avec une hauteur non constante), toutefois l'enchaînement des étapes technologiques devient alors compliqué et les contraintes associées ne permettent pas de réaliser toutes les formes désirées avec une grande fidélité géométrique.

Il convient de noter ainsi que, lors d'une étape de gravure, la vitesse de gravure est fonction des dimensions transverses et de la densité des motifs à graver (« microloading » en anglais), ce qui se traduit par le fait, notamment, que, à un instant donné, la profondeur de gravure est d'autant plus importante que les dimensions transverses du motif à graver sont grandes ; ce phénomène engendre une perte de côte des motifs suivant leur hauteur, ce qui n'est en pratique pas acceptable.

Par ailleurs, les structures gravées présentent en pratique des rugosités substantielles au fond des motifs.

En outre, il n'est pas toujours possible de décorréler les dimensions dans le plan et la hauteur pour des motifs de résines (masque original avant le transfert par gravure). On peut en effet vérifier que, si l'on trace des courbes corrélant les variations de dimensions pour un motif de résine négative obtenu par lithographie électronique, d'une part, et les variations de hauteur associée, d'autre part, en fonction de la dose (l'énergie injectée dans la résine), la dimension latérale et la hauteur varient simultanément mais selon des allures différentes de sorte qu'il n'est pas possible d'ajuster une des deux variables sans modifier l'autre. Par conséquent, la lithographie classique ne permet pas de faire varier indépendamment les dimensions I et L, d'une part, et h, d'autre part.

Les figures 3 et 4 montrent des motifs en bosses, mais les difficultés précitées se présentent également pour la réalisation de motifs en creux.

Le document FR-2 869 601 décrit la production de moules de nano-impression mettant en oeuvre la formation, dans des couches superposées, de noyaux qui sont éliminés, mais les motifs ainsi obtenus sont du type 2D (c'est-à-dire du type de la figure 3), les autres noyaux étant destinés à former des canaux et des réservoirs ne faisant pas partie des motifs de nano-impression.

Le document de JOHNSON S ET AL: "Fabrication of multi-tiered structures on step and flash imprint lithography templates", MICROELECTRONIC ENGINEERING, vol. 67-68, juin 2003 , pages 221-228, ELSEVIER PUBLISHERS BV., AMSTERDAM, NL, enseigne un procédé de fabrication d'un moule d'impression transparent qui présente des motifs de type 3D. La dimension la plus petite du moule mesure 100 nm. Le moule est produit de manière itérative: Sur un substrat une première couche est déposée et structurée, ensuite une autre couche structurelle est déposée sur la première couche et structurée elle-même. Cette approche exige une sélectivité de gravure entre les couches ou l'emploi de couches d'arrêt de gravure déposée sur chaque couche structurelle.

### Problème technique résolu par l'invention

Un objet de l'invention est de permettre de réaliser des supports présentant des motifs, en creux ou en bosses, dont les dimensions (ou les écarts) sont inférieures à une centaine de nanomètres.

Un autre objet de l'invention est de permettre la réalisation, de manière fiable et raisonnablement simple, de supports munis de motifs de type 3D, en creux ou en bosses.

Un autre objet de l'invention est de permettre la réalisation de tels supports munis de motifs avec une grande précision dimensionnelle, à la fois en largeur et en longueur et en hauteur, avec une faible rugosité des surfaces transverses.

L'invention propose à cet effet un procédé de fabrication d'un moule de nano-impression comportant un support en au moins un matériau prédéterminé et présentant des motifs, selon lequel
* on réalise, sur un substrat que l'on sait éliminer, une pluralité de couches superposées, chacune des couches étant formée de zones en au moins deux matériaux différents, la géométrie des zones et les matériaux constitutifs de ces couches superposées étant définis en sorte de former lesdits motifs, à l'envers sur le substrat, ces motifs étant de type 3D, certains de ces motifs présentant des différences de hauteur en eux-mêmes et/ou avec d'autres motifs,
* on réalise sur cet empilement de couches une couche du matériau prédéterminé, et
* on élimine au moins le substrat, grâce à quoi on obtient, après retournement, ledit support avec lesdits motifs.

L'invention enseigne ainsi de réaliser les motifs, à l'envers sur un substrat que l'on élimine à la fin, en procédant par empilement de couches dont la géométrie est définie en fonction des motifs que l'on souhaite former sur le support.

La formation des couches superposées peut avantageusement être réalisée par:
- pulvérisation cathodique ;
- épitaxie ;
- croissance électrolytique ;
- dépôt par centrifugation.

Pour la couche du matériau prédéterminé, on pourra utiliser des techniques de dépôt standard (pulvérisation, croissance électrolytique, dépôt par jet moléculaire ...) ou plus originales comme le collage moléculaire ou le dépôt par centrifugation d'un matériau fluide qui pourra devenir solide après une ou des étapes de recuit.

Grâce à la mise en oeuvre d'une succession de couches, le procédé de l'invention permet une grande précision en largeur et en longueur, permettant des dimensions de l'ordre de quelques dizaines de nanomètres seulement.

Par ailleurs, les techniques de formation de couches sont bien maîtrisées, ce qui permet de bien contrôler les hauteurs des motifs, indépendamment de la précision en longueur et en largeur. En effet, la hauteur désirée peut être obtenue avec une grande précision, puisque celle-ci dépend uniquement de l'étape de dépôt (à ce stade, les épaisseurs déposées sont maîtrisées avec une précision de l'ordre de 0.1 nm) et non plus de l'étape de gravure. Puisque les dimensions dans le plan (I, L) peuvent être bien contrôlées par les techniques de lithographie classiques, on comprend que, grâce au procédé de l'invention les 3 dimensions (h, I et L) sont parfaitement maîtrisées. Le procédé de l'invention permet donc de réaliser des motifs 3D tout en utilisant des procédés de lithographie et gravure simples, bien connus et maîtrisés par l'homme du métier.

On comprend aisément en outre que, par mise à nu de la surface de chaque couche, on permet d'obtenir une faible rugosité. En fait, selon l'invention, les étapes de gravure intervenant lors de la formation de chaque couche sont choisies en fonction de leur sélectivité entre les deux familles de matériaux utilisés, sans se préoccuper de la rugosité résultante puisque celle-ci provient essentiellement, du fait de la succession d'étapes proposée, des conditions de dépôt ; or le dépôt est un procédé qui permet de réaliser des couches avec de très faible rugosité. En d'autres termes, la présente invention, grâce à la notion de couches successivement formées et mises à nu, conduit à l'obtention de surfaces parfaitement planes exemptes des rugosités observées sur les structures gravées.

On peut noter que, grâce à cette structure en couche, on s'affranchit des phénomènes de vitesses différentielles de gravure en fonction des dimensions transverses des motifs gravés (« microloading » en terminologie anglo-saxonne).

Il mérite d'être noté que l'ensemble du procédé est compatible avec les procédés de la microélectronique et des microtechnologies puisqu'il met en oeuvre des techniques compatibles avec ces procédés.

Enfin, le procédé de l'invention permet de préparer, indifféremment, des supports, moules, masques, présentant une topographie en « bosse » ou en « creux ». Par conséquent, il est possible de réaliser des supports qui permettent d'adresser des masques de résines à fond :
- foncé, c'est-à-dire avec peu d'ouverture dans le masque de résine obtenu avec un moule présentant des bosses (c'est équivalent à faire une étape de lithographie classique avec de la résine à tonalité positive),
- clair, c'est-à-dire avec beaucoup d'ouverture dans le masque de résine obtenu avec un moule présentant des creux (c'est équivalent à faire une étape de lithographie classique avec de la résine à tonalité négative).

Dans ces conditions, la technique proposée pour la fabrication de structures tridimensionnelles permet de contrôler très précisément la phase de l'onde optique d'un masque à décalage de phase dans la plus petite structure et en s'affranchissant également des phénomènes de rugosité.

En conclusion, le procédé proposé permet de résoudre les différents points suivants énoncés ci-dessus à propos des solutions connues :
- gravure du quartz sur des substrats relativement épais (plusieurs centaines de microns),
- rugosité du fond du motif gravé, ce qui pénalise la qualité du masque transparent,
- possibilité de réaliser simplement des motifs en 3 dimensions,
- contrôle très précis de la phase pour ce qui est des masques à décalage de phase,
- possibilité de faire des structures en « bosses » ou en « creux ».

Les avantages précités découlent de la définition générale de l'invention donnée ci-dessus, ou de diverses caractéristiques avantageuses de l'invention qui peuvent être proposées, éventuellement combinées.

C'est ainsi que l'invention permet bien évidemment de réaliser des motifs en 2D mais que, pour en tirer tout le profit, il est avantageux que lesdits motifs présentent des différences de hauteur.

De même, bien que l'invention puisse être mise en oeuvre indépendamment des dimensions transversales des motifs ou des écarts entre ceux-ci, il est avantageux, pour en tirer tout le profit, que certains au moins des motifs, ou au moins certains écarts entre des motifs adjacents, aient une dimension parallèle au support qui est inférieure à une centaine de nanomètres.

Selon une autre caractéristique avantageuse, les matériaux constitutifs des couches superposées ont des propriétés différentes vis-à-vis d'au moins un rayonnement, comportant au moins un matériau sensiblement transparent à ce rayonnement et un matériau absorbant vis-à-vis de ce rayonnement, lesdits motifs étant délimités par les interfaces, au sein des couches, entre lesdits matériaux. Ceci correspond à un masque dont la géométrie extérieure peut être limitée par des surfaces simples mais qui comporte dans sa masse des portions présentant des différences de comportement vis-à-vis d'un rayonnement donné.

Toutefois, selon une variante tout particulièrement avantageuse, on élimine en outre au moins un des matériaux des'couches superposées en sorte de former des motifs en creux et/ou en bosses.

Plus précisément, de manière préférée :
- on identifie un procédé d'élimination sélectif capable d'attaquer un premier matériau en laissant subsister un second matériau, ce second matériau étant capable d'être déposé sur ce premier matériau en y adhérant et de faire l'objet d'une gravure,
- on identifie au moins un matériau au moins compatible avec ce premier matériau, capable d'être déposé sur ce premier matériau en y adhérant, de faire l'objet d'une gravure et d'être consommé par ledit procédé d'élimination sélective,
- on identifie au moins un matériau au moins compatible avec ce second matériau, capable d'être déposé sur ces premier et second matériaux en y adhérant, de faire l'objet d'une gravure et de subsister vis-à-vis dudit procédé d'élimination sélective,
- on réalise un substrat formé dudit premier matériau,
- on effectue sur ce substrat un cycle de formation de dessin en sorte de former sur ce substrat une première couche formée de zones en un matériau au moins compatible avec le premier matériau et des zones complémentaires en ledit second matériau,
- on effectue au moins un autre cycle de formation de dessin en sorte de former sur la couche précédente une autre couche formée de zones en un matériau compatible avec le premier matériau et des zones complémentaires en un matériau au moins compatible avec ce second matériau, en sorte de former un empilement de couches sur le substrat,
- on solidarise la dernière couche de l'empilement avec une couche porteuse,
- on élimine par ledit procédé d'élimination sélective le premier matériau et les zones en matériau au moins compatible avec ce premier matériau en sorte de mettre à nu la superposition des zones complémentaires en second matériau ou en matériau au moins compatible avec ce second matériau, la couche porteuse formant, avec ces zones complémentaires, le support muni de motifs.

En fait, le substrat peut être formé en totalité par le premier matériau ou être une couche de ce premier matériau qui fait partie d'un substrat proprement dit.

La formation de dessin peut se faire par dépôt, gravure et mise à nu.

Les techniques permettant de réaliser les dessins sont avantageusement, notamment :
- la lithographie optique et/ou électronique sur un matériau sensible à ces rayonnements, suivie d'une étape de gravure (ces procédés sont bien connus par l'homme du métier) ;
- des procédés de croissance localisée (croissance de nodules par Microscopie à Effet Tunnel ou à Force Atomique, dépôt sur des substrats présentant des sites de croissance préférentielle comme les « substrats twistés ») ;
- une combinaison des deux techniques précédemment citées.

Selon des caractéristiques préférées de ce procédé particulier, éventuellement combinées :
- on identifie un troisième matériau permettant l'accrochage ou le collage du matériau déterminé du support sur le matériau au moins compatible avec le second matériau, on réalise sur ledit empilement de couches une couche d'accrochage en ledit troisième matériau et on réalise sur cette couche d'accrochage la couche porteuse en ledit matériau prédéterminé ;
- on utilise, à cet effet notamment, un procédé de collage moléculaire, ou un dépôt par pulvérisation, ou un dépôt électrolytique, ou un dépôt par centrifugation ;
- le dessin d'au moins une couche est différent du dessin de l'étage précédent, grâce à quoi certains au moins des motifs présentent des différences de hauteur perpendiculairement au support. Cela correspond à dire que les motifs sont de type 3D.
- l'un au moins des cycles de formation de dessin comporte une mise à nu réalisée par polissage, physique ou chimique. Cela garantit une faible rugosité de toutes les surfaces transversales, parallèles au support.
- pour les motifs comportant des portions en bosses, on identifie dans ces portions en bosse une superposition d'une tranche supérieure et d'au moins une tranche inférieure, les zones complémentaires desdites première et autre(s) couches ayant respectivement la forme de ces tranches supérieure et inférieure(s).
- par analogie, lorsque les motifs comportent des portions en creux, on identifie dans ces portions en creux une superposition d'une tranche supérieure et d'au moins une tranche inférieure, les zones desdits premier et autre(s) étages en matériau au moins compatible avec le premier matériau ayant respectivement la forme de ces tranches supérieure et inférieure(s).
- le matériau prédéterminé du support est un matériau transparent à un rayonnement donné. Cela correspond à de nombreuses applications du support comme masque ou moule de lithographie.
- le matériau prédéterminé du support est un matériau transparent à la lumière visible, ce qui correspond à un premier cas de grande importance pratique.
- en variante, le matériau prédéterminé du support est un matériau transparent aux UV; ce qui correspond à un autre cas de grande importance pratique.
- le matériau prédéterminé du support est du quartz ; en variante, il s'agit de silice fondue.
- le second matériau est constitué de silice et/ou d'oxyde thermique et le matériau au moins compatible avec ce second matériau est constitué de silice et/ou d'oxyde de silicium. Ces matériaux sont bien connus et on connaît diverses techniques d'attaque qui laissent ceux-ci intacts.
- le premier matériau et le matériau au moins compatible avec ce premier matériau sont essentiellement constitués de silicium. Il s'agit aussi d'un matériau bien connu, y compris en combinaison avec de la silice ou de l'oxyde de silicium en cas d'attaque sélective.
- selon un cas particulier, le premier matériau est du silicium monocristallin et le matériau au moins compatible avec ce premier matériau est du silicium polycristallin ou amorphe. Un autre exemple de matériau compatible avec ce premier matériau (silicium monocristallin) est du nitrure de silicium ou un alliage de silicium germanium, notamment.
- lorsque le matériau à éliminer est essentiellement constitué de silicium, le procédé d'élimination sélective comporte avantageusement une attaque par gravure humide sur oxyde, par exemple de type TMAH, KOH. Si le

matériau à éliminer est un alliage de silicium germanium, on pourra utiliser une gravure sèche CF4 (/silicium et Si3N4 et Si02). Et pour le nitrure de silicium, on pourra utiliser une solution de H3P04 (/silicium et SiO2).
- en variante, le premier matériau et le matériau au moins compatible avec ce premier matériau sont essentiellement formés d'aluminium. Ce matériau est également bien connu de l'homme de métier.
- dans le cas précité, le procédé d'élimination sélective comporte avantageusement une attaque par un bain de H3P04 ;
- selon encore une autre variante, le premier matériau et le matériau au moins compatible avec ce premier matériau sont essentiellement constitués de chrome.

L'invention propose en outre un support obtenu par le procédé précité, notamment
un moule pour lithographie par nano-impression obtenu par le procédé, ce moule étant formé d'un support et de motifs d'impression portés par ce support, les matériaux constitutifs de ce support et de ces motifs étant transparents à des rayonnements visibles UV, DUV ou EUV ; certains au moins des motifs, ou au moins certains écarts entre des motifs adjacents ont avantageusement une dimension parallèle au support qui est comprise entre quelques nanomètres et plusieurs micromètres.

### Description de l'invention

Des objets, caractéristiques et avantages de l'invention ressortent de la description qui suit, donnée à titre d'exemple illustratif non limitatif, en regard des dessins annexés sur lesquels :
- la figure 1 est un schéma d'un procédé classique de réalisation d'un support transparent comportant des portions réfléchissantes et des portions transparentes,
- la figure 2 est un schéma d'un procédé classique de réalisation d'un support transparent comportant des bosses et des creux,
- la figure 3 est un schéma représentant en perspective des motifs de type 2D,
- la figure 4 est un schéma représentant en perspective des motifs de type 3D,
- la figure 5 est une vue en coupe d'une première étape de fabrication d'un support à topographie en « bosses »,
- la figure 6 en est une vue de dessus,
- la figure 7 est une vue en coupe d'une seconde étape de fabrication de ce support,
- la figure 8 en est une vue de dessus,
- la figure 9 est une vue en coupe d'une troisième étape de fabrication de ce support,
- la figure 10 en est une vue de dessus,
- la figure 11 est une vue en coupe d'une quatrième étape de fabrication de ce support,
- la figure 12 en est une vue de dessus,
- la figure 13 est une vue en coupe d'une cinquième étape de fabrication de ce support,
- la figure 14 en est une vue de dessus,
- la figure 15 est une vue en coupe d'une sixième étape de fabrication de ce support,
- la figure 16 en est une vue de dessus,
- la figure 17 est une vue de coupe d'une septième et dernière étape de formation de ce support,
- la figure 18 en est une vue de dessous,
- la figure 19 est une vue en coupe d'une première étape de fabrication d'un support à topographie en « creux »,
- la figure 20 en est une vue de dessus,
- la figure 21 est une vue en coupe d'une seconde étape de fabrication de ce support,
- la figure 22 en est une vue de dessus,
- la figure 23 est une vue en coupe d'une troisième étape de fabrication de ce support,
- la figure 24 en est une vue de dessus,
- la figure 25 est une vue en coupe d'une quatrième étape de fabrication de ce support,
- la figure 26 en est une vue de dessus,
- la figure 27 est une vue en coupe d'une cinquième étape de fabrication de ce support,
- la figure 28 en est une vue de dessus,
- la figure 29 est une vue en coupe d'une sixième étape de fabrication de ce support,
- la figure 30 en est une vue de dessus,
- la figure 31 est une vue de coupe d'une septième et dernière étape de formation de ce support,
- la figure 32 en est une vue de dessous,
- la figure 33 est une vue en coupe d'une première configuration de masque optique à motifs opaques pour lithographie interférométrique,
- la figure 34 est une vue en coupe d'une seconde configuration de masque optique transparent à motifs en creux pour lithographie interférométrique ou pour nano impression,
- la figure 35 est une vue en coupe d'une troisième configuration de masque optique à motifs opaques 3D,
- la figure 36 est une vue en coupe d'un masque à décalage de phase,
- la figure 37 est une vue en coupe d'une première étape de fabrication d'un masque à décalage de phase,
- la figure 38 en est une vue en coupe d'une seconde étape,
- la figure 39 en est une vue en coupe d'une troisième étape,
- la figure 40 en est une vue en coupe d'une quatrième étape,
- la figure 41 en est une vue en coupe d'une cinquième étape,
- la figure 42 en est une vue en coupe d'une sixième étape,
- la figure 43 en est une vue en coupe d'une septième étape,
- la figure 44 en est une vue en coupe d'une huitième étape,
- la figure 45 est un schéma de principe de la fabrication d'un support à topographie en bosses, et
- la figure 46 est un schéma de principe de la fabrication d'un support à topographie en creux.

Dans le but de décrire des méthodes de réalisation le plus simplement possible, quelques définitions sont préalablement données.

Matériau A : support compatible avec les procédés de micro technologie de type « microélectronique », comme par exemple un substrat de silicium, ou encore silicium, dioxide de silicium, nitrure de silicium, et plus généralement les alliages à base de silicium, voire le nitrure de titane, l'aluminium, notamment.

Matériau B : matériau choisi pour ses propriétés mécaniques, optiques, thermiques ou électriques, compatible également avec les procédés de micro technologie de type « microélectronique ».

Matériau C : support final choisi pour ses propriétés mécaniques, optiques, thermiques ou électriques, a priori non nécessairement compatible avec les procédés de micro technologie de type « microélectronique ».

Matériau D : matériau choisi d'une part pour ses propriétés mécaniques, optiques, thermiques ou électriques, d'autre part pour ses propriétés de transfert, d'accrochage voire de collage sur le matériau C. Le matériau D est compatible également avec les procédés de micro technologie de type « microélectronique ».

Procédé d'élimination sélective : procédé qui permet de retirer sélectivement par voie physique ou chimique le matériau A sans dégrader le matériau B. Une garantie est pour le procédé retenu la sélectivité de vitesse de gravure du matériau B par rapport au matériau A qui doit être très grande. La sélectivité de vitesse est idéalement infinie. Toutefois, si ce n'est pas le cas, on pourra tenir compte de ce point dans les dessins originaux et alors modifier les tailles des motifs de sorte à compenser leur attaque par le procédé de retrait sélectif. La dimension de départ sera donc égale à la dimension finale visée plus la côte d'érosion due au retrait sélectif.

Matériau A' : matériau compatible avec les procédés de micro technologie de type « microélectronique » et présentant le même comportement que la matériau A vis-à-vis du procédé d'élimination sélective.

Matériau B' : matériau choisi pour ses propriétés mécaniques, optiques, thermiques ou électriques, compatible également avec les procédés de micro technologie de type « microélectronique » et présentant le même comportement que le matériau B vis-à-vis du procédé d'élimination sélective.

A titre d'exemple, pour réaliser un support présentant des motifs :
- on identifie un procédé d'élimination sélectif capable d'attaquer un premier matériau A en laissant subsister un second matériau B, ce second matériau étant capable d'être déposé sur ce premier matériau en y adhérant et de faire l'objet d'une gravure,
- on identifie au moins un matériau A' au moins compatible avec ce premier matériau, c'est-à-dire capable d'être déposé sur ce premier matériau en y adhérant, de faire l'objet d'une gravure et d'être consommé par ledit procédé d'élimination sélective,

- on identifie au moins un matériau B' au moins compatible avec ce second matériau, c'est-à-dire capable d'être déposé sur ces premier et second matériaux en y adhérant, de faire l'objet d'une gravure et de subsister vis-à-vis dudit procédé d'élimination sélective,
- on identifie un troisième matériau D permettant l'accrochage ou le collage du matériau prédéterminé C du support sur le matériau au moins compatible avec le second matériau.

Il va de soi que la notion de matériau compatible avec un autre matériau englobe cet autre matériau (un matériau est en effet compatible avec lui-même).

Le fait de préciser que tel ou tel matériau est compatible avec les procédés de micro technologie signifie en fait que ce matériau peut supporter toutes les opérations classiques intervenant dans de tels procédés, notamment pour les dépôts de couches et les formations de dessins, mais aussi ultérieurement en cas de traitement thermique.

Deux exemples sont décrits ci-dessous, correspondant à des supports comportant une topographie en bosse ou en creux, mais on comprend aisément que ces notions sont aisément combinables (une topographie peut comporter à la fois des bosses et des creux).

### • Exemple de réalisation d'un support comportant une topographie en « bosse ».

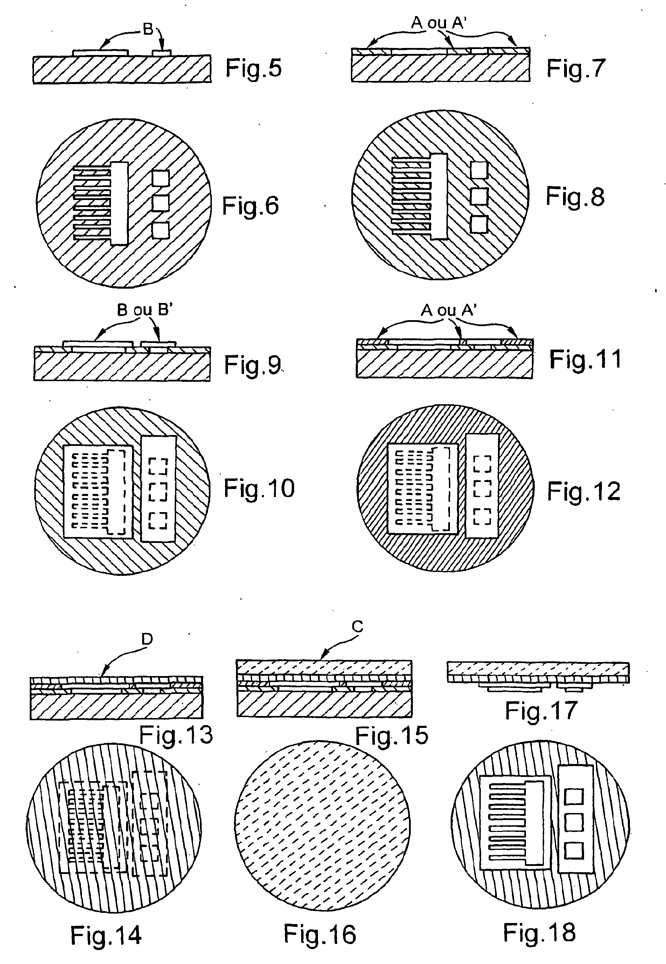

Un dépôt du matériau B (par exemple de la silice ou de l'oxyde de silicium déposé par CVD) est effectué sur le matériau A, avantageusement du silicium. Le matériau B subit alors une étape de formation de dessin (« patteming » en anglais) - lithographie + gravure + stripping - afin de réaliser des motifs 2D du matériau B sur le matériau A (figures 5 et 6).

Puis un matériau A ou A' (on choisira avantageusement du silicium polycristallin ou amorphe) est déposé sur les structures précédemment réalisées. Une étape de planarisation par technique de polissage mécano chimique est effectuée avec arrêt sur le matériau B, qui apparaît donc en surface (figures 7 et 8).

On effectue à nouveau un dépôt et une étape de « patterning » du matériau B ou B ' (figures 9 et 10). Puis, un dépôt du matériau A ou A' avec une étape de planarisation est effectuée (figures 11 et 12). Le matériau B ou B' apparaît donc encore à la surface.

Après un nombre d'itérations nécessaires à la réalisation de la structure tridimensionnelle (dépôt et étape de patteming du matériau B ou B', avec dépôt, gravure et planarisation du matériau A ou A'), le matériau D (silice, oxyde de silicium) est déposé (figures 13 et 14). Un matériau C (quartz ou silice fondue, par exemple) est alors déposé. L'épaisseur de ce matériau et avantageusement choisie pour répondre aux propriétés (optiques, mécaniques, thermiques...) nécessaires pour l'utilisation du support réalisé (figures 15 et 16).

Le procédé se termine par une étape d'élimination sélective, qui consiste à ne conserver que le matériau B ou B' sur la couche D et C, le matériau A ayant été totalement supprimé (figures 17 et 18). On peut, à cet effet, utiliser un polissage mécano chimique terminé par une gravure sélective Silicium (matériau A ou A') sur oxyde (matériau B ou B', D) de type TMAH (tétra méthyl ammonium hydroxyde).

On obtient ainsi un support réalisé en matériau C sur lequel des motifs en matériau B (ou B') apparaissent en bosses.

### • Exemple de réalisation d'un support comportant une topographie en « creux ».

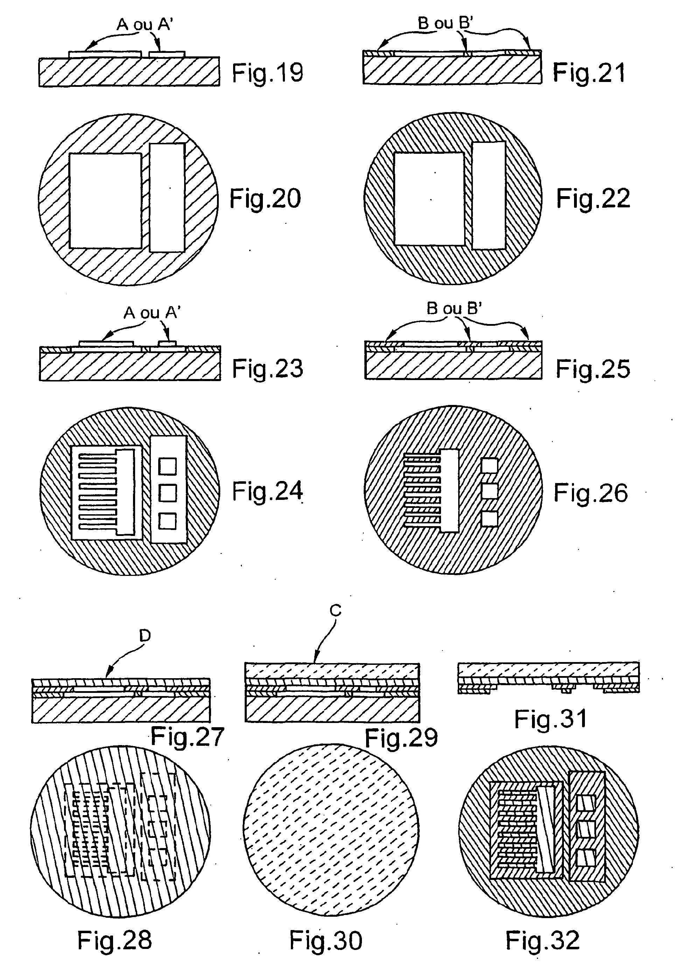

Un dépôt du matériau A ou A' (par exemple du silicium) est effectué sur un substrat qui est avantageusement de même nature (matériau A). Le matériau A subit alors une étape de formation de dessin ou « patterning » (lithographie + gravure+ stripping) afin de réaliser de motifs 2D en matériau A sur le substrat (figures 19 et 20).

Puis un matériau B ou B' (par exemple de l'oxyde de silicium) est déposé sur les structures précédemment réalisées. Une étape de planarisation par technique de polissage mécano chimique est effectuée avec arrêt sur le matériau A, qui apparaît donc en surface (figures 21 et 22).

On effectue à nouveau un dépôt et une étape de « patteming » du matériau A ou A' (figures 23 et 24). Puis, un dépôt du matériau B ou B' avec une étape de planarisation est effectuée (figures 25 et 26). Le matériau A ou A' apparaît donc à la surface.

Après un nombre d'itérations nécessaires à la réalisation de la structure tridimensionnelle (dépôt et étape de patteming du matériau A ou A' et dépôt et planarisation du matériau B ou B'), le matériau D (silice, oxyde de silicium) est déposé (figures 27 et 28). Un matériau C (quartz, silice fondue) est alors déposé (figures 29 et 30). L'épaisseur de ce matériau est avantageusement choisie pour répondre aux propriétés (optiques, mécaniques, thermiques...) nécessaires pour l'utilisation du support réalisé.

Le procédé se termine par une étape d'élimination sélective, qui consiste à ne conserver que le matériau B ou B' sur la couche D et C, le matériau A ou A' ayant été totalement supprimé (figures 31 et 32). On peut utiliser un polissage mécano chimique terminé par une gravure sélective Silicium (matériau A ou A') sur oxyde (matériau B ou B', D) de type TMAH.

Ce procédé peut être utilisé afin de fabriquer des moules sur quartz ou silice fondue pour lithographie par nano-impression (NIL) dans une configuration de « step and flash). Cette technique fait intervenir un moule transparent au rayonnement UV pour la transformation des polymères, sous le moule, lors de l'opération de pressage. Par conséquent, le tableau ci-dessous propose une configuration facilement utilisable dans un environnement de type micro-électronique.

| | |
|---|---|
| Matériau A | Substrat de silicium |
| Matériau A' | Polysilicium ou silicium amorphe |
| Matériau B | Silice - Oxyde thermique Si02 ou déposée par CVD |
| Matériau B' | Silice - Oxyde de silicium déposé par CVD (HTO Hte T° ou TEOS Basse T°) |
| Matériau C | Substrat de Quartz ou de silice fondue |
| Matériau D | Silice -Oxyde de silicium déposé par CVD (HTO Hte T° ou TEOS Basse T°) |
| Procédé d'élimination sélectif | Polissage mécano-chimique terminé par une gravure sélective Silicium sur oxyde de type TMAH. |

Dans le tableau précité, CVD est l'expression anglaise pour Chemical Vapor Deposition, ce qui signifie Dépôt de vapeur chimique.

Pour ce qui est de la fabrication de réseaux de diffraction de dimensions largement submicroniques (quelques dizaines de nanomètres) sur silice fondue pour application interférométrie optique UV profonds, les matériaux B, B' et C doivent être transparents aux rayonnements DUV (longueur d'onde inférieure à 248 nm). Le tableau ci-dessous résume les choix possibles pour les différents matériaux.

| | |
|---|---|
| Matériau A | Substrat de silicium |
| Matériau B | Oxyde thermique Si02 |
| Matériau C | Substrat de silice fondue |
| Matériau D | Silice - Oxyde de silicium déposé par CVD (HTO Hte T° ou TEOS Basse T° |
| Procédé d'élimination sélectif | Polissage mécano-chimique terminé par une gravure sélective Silicium sur oxyde de type TMAH. |

Bien évidemment, d'autres matériaux que le silicium peuvent être utilisés pour ce qui est du matériau A. Par exemple, de l'aluminium est totalement compatible avec ce procédé. Il suffit d'utiliser un bain d'H₃PO₄ pour supprimer sélectivement ce matériau sans affecter le matériau transparent mis en forme.

Le chrome peut également être utilisé et retiré avec une solution bien connue de l'homme du métier : le « chrome etch ».

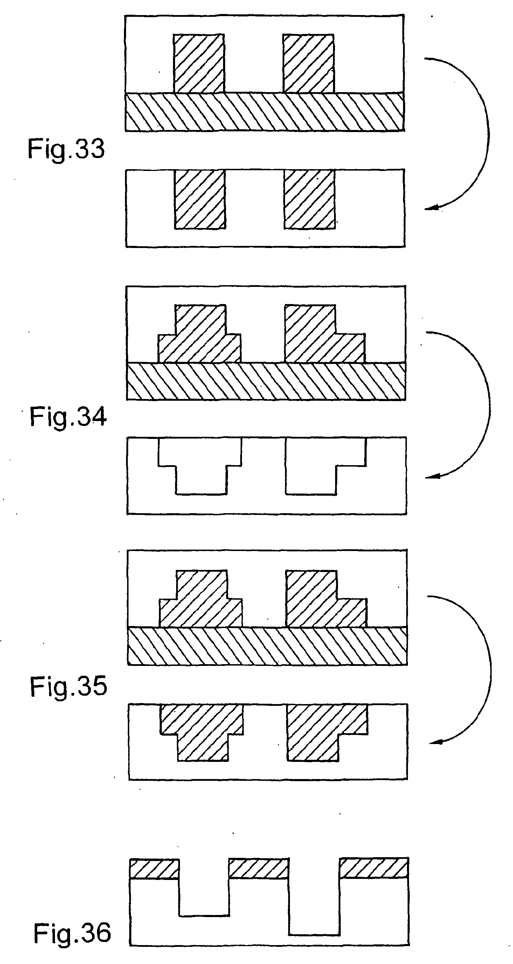

Typiquement, quatre configurations sont avantageusement réalisables avec le présent procédé :
- une configuration avec un support transparent dans lequel sont noyés des motifs absorbants de type 2D (figure 33) ; cette configuration est utilisable pour un masque optique, notamment,
- une configuration avec un support entièrement transparent avec des creux qui peuvent être de type 3D (figure 34) ; cette configuration est utilisable notamment pour les masques optiques ou les moules transparents pour la nano impression « step and flash »,
- une configuration avec un support transparent dans lequel sont noyés des motifs opaques de type 3D (figure 35) ; cette configuration est notamment utilisable pour les masques optiques,
- une configuration avec un support non transparent avec des creux qui peuvent être de type 3D ; cette configuration est utilisable notamment pour le « hot embossing » ou plus couramment appelé « nano-imprint lithography ».

On peut remarquer que dans les première et troisième configurations, le support final est délimité par des surfaces supérieure et inférieure planes, les motifs étant délimités par des interfaces entre les matériaux constitutifs.

Parmi les applications des supports pouvant être obtenus par l'invention, on a vu les moules pour la lithographie par nano impression, les masques de lithographie interférométrique optique ; on peut aussi mentionner les masques optiques à décalage de phase pour la lithographie optique.

### Application pour la fabrication de masque à décalage de phase

Le procédé tel qu'il a été décrit plus haut peut aisément s'adapter à la fabrication de masques à décalage de phase.

Pourtant, la fabrication de masques à décalage de phase ne fait pas partie de la présente invention.

Le principe des masques à décalage de phase est représenté par la figure 36, avec un support transparent présentant des creux de profondeurs variables séparés par des saillies terminées par des portions opaques.

Différentes parties transparentes du masque ne possèdent pas la même épaisseur, ce qui a pour conséquence de modifier le chemin optique du faisceau lumineux à travers le masque. Cette technologie permet d'augmenter très sensiblement la résolution atteignable avec un équipement de photo lithographie optique [voir Resolution enhancement techniques in optical lithography, A.K. Wong, 2001, SPIE Press] comparativement à l'utilisation d'un masque binaire, c'est-à-dire ne comportant que des zones opaques et transparentes, toutes avec la même épaisseur. Il existe différents types de masque à décalage de phase. Le tableau ci-dessous résume les différentes possibilités existantes.

| Type de phase | Autre nom | Catégorie | Situations applicables |
|---|---|---|---|
| Alternée | Levenson | Forte | Espaces et lignes groupés |
| déphasage de bord | | Faible | Contacts, structures isolées |
| Atténuée | Chrome en fuite, demi-ton | Faible | Contacts, structures isolées |
| Bord de phase | Sans Chrome | Forte | Lignes étroites |
| Outrigger | Sous Résolution | Faible | Structures isolées |

Ou en anglais :

| Type of phase | Alternate name | Category | Applicable situations |
|---|---|---|---|
| Alternating | Levenson | Strong | Grouped lines and spaces |
| Rim shift | | Weak | Contacts, isolated features |
| Attenuated | Leaky chrome, half-tone | Weak | Contacts, isolated features |
| Phase-edge | Chromeless | Strong | Narrow lines |
| Outrigger | Subresolution | Weak | Isolated features |

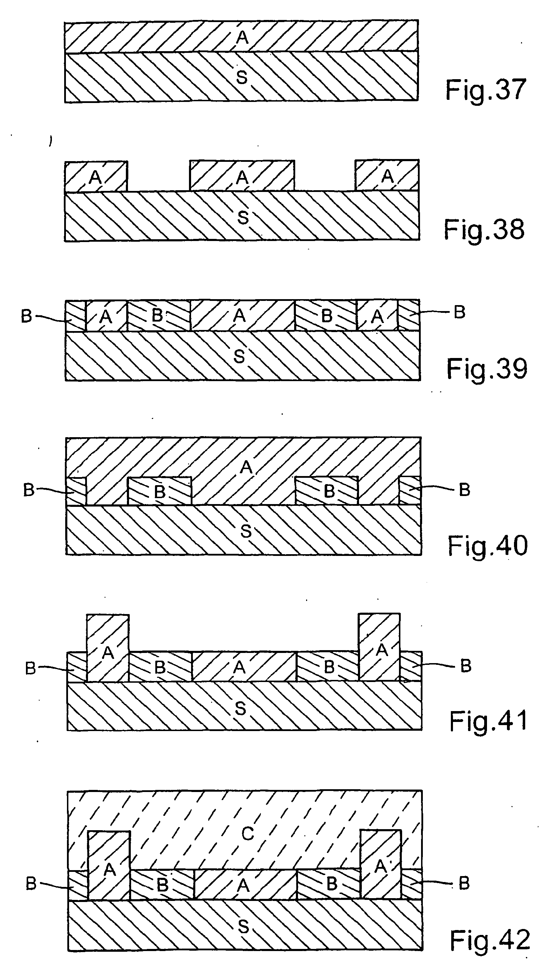

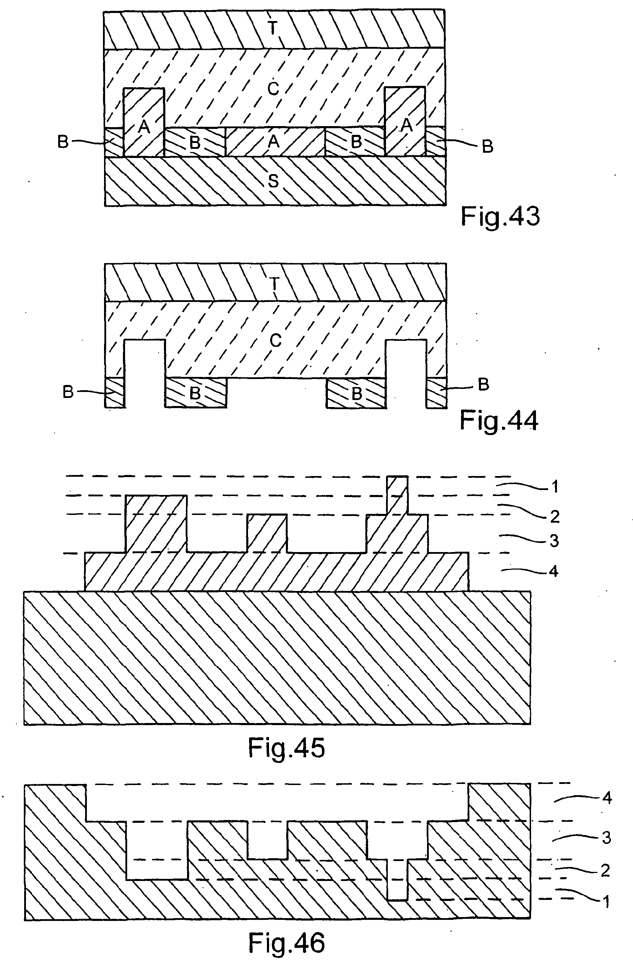

Le procédé de la présente invention permet de réaliser n'importe laquelle de toutes ces familles de masque à décalage de phase. Par exemple, si on considère le cas des masques dit « altemating » pour lesquels une gravure du matériau transparent (typiquement de la silice dopée) est nécessaire, les étapes sont les suivantes :
Avec le présent procédé, les étapes sont les suivantes :
   - étape 1 : une couche A est déposée sur le substrat en matériau A (figure 37,
   - étape 2: lithographie (en sorte de former un masque) puis gravure de cette couche A (figure 38),
   - étape 3 : dépôt du matériau B (opaque) et planarisation en sorte de laisser affleurer la couche A gravée (figure 39),
   - étape 4 : dépôt d'une couche A complémentaire (figure 40),
   - étape 5 : lithographie puis gravure de cette seconde couche en matériau A (figure 41),
   - étape 6: dépôt du matériau C (transparent) et planarisation (figure 42),
   - étape 7 : collage de la couche C qui supportera le matériau B sur un substrat transparent T (figure 43),
   - étape 8 : élimination du substrat et du matériau A (figure 44).

Les figures 45 et 46 indiquent à titre d'exemple l'analyse qui peut être faite d'un support muni de motifs que l'on veut fabriquer selon l'invention.

A la figure 45 qui représente un support muni de motifs en « bosse », c'est-à-dire en saillie, on commence par identifier les plans horizontaux dans lesquels il y a un changement de forme de l'un au moins des motifs : les espaces entre ces plans indiquent les couches qu'il faut distinguer lors de la fabrication du support considéré : il y a ainsi au moins une couche 1 pour former la partie supérieure du motif de droite, puis une couche 2 pour former la suite vers le bas de ce motif de droite et la partie supérieure du motif de gauche, puis une couche 3 pour la base de chacun des trois motifs (étant noté que le motif du milieu a la même hauteur que la base du motif de droite), puis une couche 4 pour le socle commun à ces trois motifs. Pour la fabrication, on réalise d'abord la couche 1, puis la couche 2, puis la couche 3 puis la couche 4, à l'envers d'un support.

La procédure est analogue avec le cas du support de la figure 46 dont la topographie est en creux.

Il convient de noter que l'invention permet un très bon contrôle dimensionnel des motifs réalisés (aussi bien en largeur qu'en hauteur), avec des arêtes bien nettes, ce qui se révèle très difficile par les techniques connues, et ce sans limitation quant à la nature (composition chimique, dureté, stabilité géométrique en service, capacité à être recouvert de manière efficace par un revêtement tel qu'un revêtement anti-adhésif dans le cas d'un moule, etc.) des matériaux utilisés, lesquels peuvent donc être choisis en fonction de leurs fonctions futures (notamment caractéristiques de transparence à des rayonnements particuliers, tenue thermique, tenue mécanique, etc.) ; en particulier l'invention permet de réaliser des motifs totalement transparents à des rayonnements tels que les UV. De plus, elle permet de s'affranchir des difficultés liées à la gravure du quartz (notamment en raison de la corrélation entre la largeur et la profondeur des zones gravées) lorsqu'on veut réaliser des objets 3D transparents aux UV par exemple. De même elle permet de s'abstenir de la formation de couches d'arrêt de gravure, qui de toute façon, ne permettraient pas de réaliser avec précision les divers niveaux de hauteur voulus avec une grande précision.

Il convient également de noter que l'invention permet de réaliser des objets dans lesquels des motifs sont formés, sans nécessairement éliminer une partie des couches empilées : c'est ainsi que l'invention permet de former des motifs opaques entourés d'une matière transparente par rapport à un rayonnement donné (UV par exemple).

Il convient en outre de noter que l'invention permet de combiner plusieurs matériaux au sein du support muni des motifs, soit que les motifs soient (en tout ou partie) en un matériau différent de celui du support, soit que certains des motifs soient en un (ou plusieurs) matériau(x) différent(s) de celui (ou ceux) d'autres motifs. C'est ainsi par exemple, en choisissant de manière appropriée le matériau B' et le matériau B dans l'empilement de couches décrit aux figures , on peut réaliser au sein des motifs des strates de matériaux différents, pour obtenir notamment des effets différents des points de vue transparence ou thermique ; en variante, on peut réaliser certains motifs dans le matériau B et d'autre motifs dans le matériau B' ; bien entendu, ce qui précède mentionne deux matériaux différents, mais on comprend qu'il peut y avoir un nombre supérieur de matériaux B, B', B" etc., dès lors que ces matériaux respectent les conditions exprimées dans la définition donnée ci-dessus de ce à quoi correspond un matériau B'. En outre, en choisissant ces matériaux B et B' différents du matériau C du support, il est possible par exemple de former des motifs en un matériau présentant un coefficient de dilatation thermique négatif (à la différence du support), ce qui permet aussi de réaliser, par impression à chaud, des motifs ayant des géométries plus petites que celles avec lesquelles les motifs ont été réalisés ; cela permet d'obtenir pour les motifs imprimés une résolution meilleure que celle avec laquelle les motifs du moule ont été réalisés. En variante, un choix approprié des divers coefficients de dilatation thermique peut faciliter le démoulage. Le support peut même être réalisé lui-même en plusieurs matériaux (C, C' etc.) si cela paraît utile. De manière générale, la possibilité de pouvoir choisir les divers matériaux B et B' (voire B" etc.) et C permet d'optimiser au mieux les contraintes, notamment thermiques et mécaniques, qu'on peut souhaiter obtenir au sein de l'objet réalisé par l'invention.

## Revendications

1. Procédé de fabrication d'un moule de nano-impression comportant un support en au moins un matériau prédéterminé et présentant des motifs, selon lequel
- on réalise, sur un substrat que l'on sait éliminer, une pluralité de couches superposées, chacune des couches étant formée de zones en au moins deux matériaux différents, la géométrie des zones et les matériaux constitutifs de ces couches superposées étant définis en sorte de former lesdits motifs, à l'envers sur le substrat, ces motifs étant de type 3D, certains de ces motifs présentant des différences de hauteur en eux-mêmes et/ou avec d'autres motifs,
- on réalise sur cet empilement de couches une couche du matériau prédéterminé, et
- on élimine au moins le substrat et au moins un des matériaux des couches superposées en sorte de former lesdits motifs, en creux et/ou en bosses, grâce à quoi on obtient, après retournement, ledit support avec lesdits motifs.

2. Procédé selon la revendication 1, **caractérisé en ce que** certains au moins des motifs, ou au moins certains écarts entre des motifs adjacents, ont une dimension parallèle au support qui est inférieure à une centaine de nanomètres.

3. Procédé selon la revendication 1 ou la revendication 2 selon lequel :
- on identifie un procédé d'élimination sélectif capable d'attaquer un premier matériau en laissant subsister un second matériau, ce second matériau étant capable d'être déposé sur ce premier matériau en y adhérant et de faire l'objet d'une gravure,
- on identifie au moins un matériau au moins compatible avec ce premier matériau, capable d'être déposé sur ce premier matériau en y adhérant, de faire l'objet d'une gravure et d'être consommé par ledit procédé d'élimination sélective,
- on identifie au moins un matériau au moins compatible avec ce second matériau, capable d'être déposé sur ces premier et second matériaux en y adhérant, de faire l'objet d'une gravure et de subsister vis-à-vis dudit procédé d'élimination sélective,
- on réalise un substrat formé dudit premier matériau,
- on effectue sur ce substrat un cycle de formation de dessin en sorte de former sur ce substrat une première couche formée de zones en un matériau au moins compatible avec le premier matériau et des zones complémentaires en ledit second matériau,
- on effectue au moins un autre cycle de formation de dessin en sorte de former sur la couche précédente une autre couche formée de zones en un matériau compatible avec le premier matériau et des zones complémentaires en un matériau au moins compatible avec ce second matériau, en sorte de former un empilement de couches sur le substrat,
- on solidarise la dernière couche de l'empilement avec une couche porteuse formée du matériau prédéterminé,
- on élimine par ledit procédé d'élimination sélective le premier matériau et les zones en matériau au moins compatible avec ce premier matériau en sorte de mettre à nu la superposition des zones complémentaires en second matériau ou en matériau au moins compatible avec ce second matériau, la couche porteuse formant, avec ces zones complémentaires, le moule muni desdits motifs.

4. Procédé selon la revendication 3, **caractérisé en ce que** la formation de dessin se fait par dépôt, gravure et mise à nu.

5. Procédé selon l'une quelconque des revendications 3 et 4, **caractérisé en ce que** le matériau prédéterminé de la couche porteuse et le(s) matériau(x) des couches complémentaires sont des matériaux transparents à un rayonnement donné.

6. Procédé selon la revendication 5, **caractérisé en ce que** ces matériaux sont transparents à la lumière visible.

7. Procédé selon la revendication 5, **caractérisé en ce que** ces matériaux sont transparents aux UV.

8. Procédé selon l'une quelconque des revendications 3 à 7, **caractérisé en ce que** le second matériau est constitué de silice et/ou d'oxyde thermique et le matériau au moins compatible avec ce second matériau est constitué de silice et/ou d'oxyde de silicium.

9. Procédé selon l'une quelconque des revendications 3 à 8, **caractérisé en ce que** le premier matériau et le matériau au moins compatible avec ce premier matériau sont essentiellement constitués de silicium,

10. Procédé selon l'une quelconque des revendications 3 à 8, **caractérisé en ce que** le premier matériau et le matériau au moins compatible avec ce premier matériau sont essentiellement formés d'aluminium.

11. Procédé selon l'une quelconque des revendications 3 à 8, **caractérisé en ce que** le premier matériau et le matériau au moins compatible avec ce premier matériau sont essentiellement constitués de chrome.

12. Moule pour lithographie par nano-impression obtenu par le procédé selon l'une quelconque des revendications 1 à 11, ce moule étant formé d'un support et de motifs d'impression portés par ce support, les matériaux constitutifs de ce support et de ces motifs étant transparents à des rayonnements visibles UV, DUV ou EUV.

13. Moule selon la revendication 12, **caractérisé en ce que** certains au moins des motifs, ou au moins certains écarts entre des motifs adjacents ont une dimension parallèle au support qui est comprise entre quelques nanomètres et plusieurs micromètres.

## Claims

1. Method of fabricating a nano-imprint mould comprising a support from at least one predetermined material and including patterns, wherein
- a plurality of superposed layers is produced on a substrate the elimination of which it is known how to perform, each of the layers being formed of areas of at least two different materials, the geometry of the areas and the materials constituting the superposed layers being defined to form said patterns in reverse on the substrate, these patterns being of 3D type, some of these patterns having height differences within themselves and/or compared to other patterns,
- a layer of the predetermined material is produced on the stack of layers, and
- at least the substrate and at least one of the materials of the superposed layers are eliminated so as to form said patterns, in the form of recesses and/or projections, whereby, after flipping, said support with said patterns is obtained.

2. Method according to claim 1, **characterized in that** at least some of the patterns, or at least some of the separations between adjacent patterns, have a dimension parallel to the support that is less than approximately 100 nanometers.

3. Method according to claim 1 or claim 2 wherein:
- a selective elimination process is identified capable of attacking a first material and leaving a second material, which second material can be deposited on the first material, adhering thereto, and be etched,
- at least one material is identified at least compatible with the first material, which can be deposited on the first material, adhering thereto, be etched and be consumed by said selective elimination process,
- at least one material is identified at least compatible with the second material, which can be deposited on these first and second materials, adhering thereto, be etched and not be consumed by said selective elimination process,
- a substrate formed of said first material is produced,
- a patterning cycle is effected on the substrate so as to form on the substrate a first layer formed of areas of a material at least compatible with the first material and complementary areas of said second material,
- at least one other patterning cycle is effected to form on the preceding layer another layer formed of areas of a material compatible with the first material and complementary areas of a material at least compatible with the second material, so as to form a stack of layers on the substrate,
- the last layer of the stack is attached to a carrier layer formed from the predetermined material,
- said selective elimination process is used to eliminate the first material and the areas of material at least compatible with the first material so as to strip the stack of complementary areas of the second material or of material at least compatible with the second material, the carrier layer forming, with these complementary areas, the mold provided with said patterns.

4. Method according to claim 3, **characterized in that** the patterning is effected by deposition, etching and stripping.

5. Method according to any one of claims 3 and 4, **characterized in that** the predetermined material of the carrier layer and the material or materials of the complementary layers are materials transparent to a given radiation.

6. Method according to claim 5, **characterized in that** those materials are transparent to visible light.

7. Method according to claim 5, **characterized in that** those materials are transparent to UV.

8. Method according to any one of claims 3 to 7, **characterized in that** the second material is constituted by silica and/or thermal oxide and the material at least compatible with the second material is constituted by silica and/or silicon oxide.

9. Method according to any one of claims 3 to 8, **characterized in that** the first material and the material at least compatible with the first material are essentially constituted by silicon.

10. Method according to any one of claims 3 to 8, **characterized in that** the first material and the material at least compatible with the first material are essentially formed of aluminum.

11. Method according to any one of claims 3 to 8, **characterized in that** the first material and the material at least compatible with the first material are essentially constituted by chromium.

12. Mould for nano-imprint lithography obtained by the method according to any one of claims 1 to 11, said mould being formed of a support and printing patterns carried by that support, the materials constituting the support and the patterns being transparent to visible UV, DUV or EUV radiation.

13. Mould according to claim 12, **characterized in that** at least some of the patterns, or at least some of the separations between adjacent patterns, have a dimension parallel to the support that is between a few nanometers and a few micrometers.

## Patentansprüche

1. Verfahren zum Herstellen einer Prägeform für das Nanoprägen, die einen Träger aus zumindest einem vorbestimmten Material enthält und Muster aufweist, wobei
- auf einem Substrat, das beseitigt werden kann, eine Mehrzahl von übereinanderliegenden Schichten ausgebildet wird, wobei die Schichten jeweils aus Bereichen aus zumindest zwei unterschiedlichen Materialien gebildet werden, wobei die Geometrie der Bereiche und die Materialien, aus denen diese übereinanderliegenden Schichten bestehen, derart definiert sind, dass die Muster seitenverkehrt auf dem Substrat ausgebildet werden, wobei diese Muster 3D-artig sind, wobei bestimmte dieser Muster in sich und/oder gegenüber weiteren Mustern Höhenunterschiede aufweisen,
- auf diese Schichtpackung eine Schicht aus dem vorbestimmten Material ausgebildet wird, und
- zumindest das Substrat und zumindest eines der Materialien der übereinanderliegenden Schichten beseitigt wird, so dass die Muster als Vertiefung und/oder als Erhebung entstehen, wodurch nach Wenden der Träger mit den Mustern erhalten wird.

2. Verfahren nach Anspruch 1,
**dadurch gekennzeichnet, dass** zumindest bestimmte der Muster oder zumindest bestimmte Zwischenräume zwischen aneinandergrenzenden Mustern eine Abmessung parallel zum Träger haben, die kleiner als etwa hundert Nanometer ist.

3. Verfahren nach Anspruch 1 oder nach Anspruch 2, wobei
- ein selektives Beseitigungsverfahren bestimmt wird, mit welchem ein erstes Material angegriffen werden kann und dabei ein zweites Material bestehen bleibt, wobei dieses zweite Material auf dieses erste Material aufgebracht werden kann, indem es daran anhaftet und geätzt werden kann,
- zumindest ein Material bestimmt wird, das zumindest mit diesem ersten Material kompatibel ist, auf dieses erste Material aufgebracht werden kann, indem es daran anhaftet, geätzt werden kann und durch das selektive Beseitigungsverfahren abgetragen werden kann,
- zumindest ein Material bestimmt wird, das zumindest mit diesem zweiten Material kompatibel ist, auf dieses erste und zweite Material aufgebracht werden kann, indem es daran anhaftet, geätzt werden kann und beim selektiven Beseitigungsverfahren bestehen bleiben kann,
- ein aus dem ersten Material gebildetes Substrat hergestellt wird,
- auf diesem Substrat ein Arbeitsgang zum Ausbilden eines Motivs erfolgt, so dass auf diesem Substrat eine erste Schicht ausgebildet wird, die aus Bereichen aus einem Material gebildet wird, das zumindest mit dem ersten Material kompatibel ist, sowie aus komplementären Bereichen aus dem zweiten Material,
- zumindest ein weiterer Arbeitsgang zum Ausbilden eines Motivs erfolgt, so dass auf der vorhergehenden Schicht eine weitere Schicht ausgebildet wird, die aus Bereichen aus einem Material gebildet wird, das mit dem ersten Material kompatibel ist, sowie aus komplementären Bereichen aus einem Material, das zumindest mit diesem zweiten Material kompatibel ist, so dass eine Packung von Schichten auf dem Substrat ausgebildet wird,
- die letzte Schicht der Packung fest mit einer Trägerschicht verbunden wird, die aus dem vorbestimmten Material hergestellt ist,
- mit dem selektiven Beseitigungsverfahren das erste Material und die Bereiche aus dem Material, das zumindest mit diesem ersten Material kompatibel ist, beseitigt werden, so dass die Übereinanderlagerung von komplementären Bereichen aus dem zweiten Material bzw. aus dem Material, das zumindest mit diesem zweiten Material kompatibel ist, freigelegt wird, wobei die Trägerschicht mit diesen komplementären Bereichen die mit den Mustern versehene Prägeform bildet.

4. Verfahren nach Anspruch 3,
**dadurch gekennzeichnet, dass** die Bildung des Motivs durch Beschichtung, Ätzung und Freilegung erfolgt.

5. Verfahren nach einem der Ansprüche 3 und 4,
**dadurch gekennzeichnet, dass** das vorbestimmte Material der Trägerschicht und das bzw. die Materialien der komplementären Schichten Materialien sind, die bei einer gegebenen Strahlung transparent sind.

6. Verfahren nach Anspruch 5,
**dadurch gekennzeichnet, dass** diese Materialien bei sichtbarem Licht transparent sind.

7. Verfahren nach Anspruch 5,
**dadurch gekennzeichnet, dass** diese Materialien bei UV-Strahlung transparent sind.

8. Verfahren nach einem der Ansprüche 3 bis 7,
**dadurch gekennzeichnet, dass** das zweite Material aus Silica und/oder thermisch erzeugtem Oxid besteht und das Material, das zumindest mit dem zweiten Material kompatibel ist, aus Silica und/oder Siliziumoxid besteht.

9. Verfahren nach einem der Ansprüche 3 bis 8,
**dadurch gekennzeichnet, dass** das erste Material und das zumindest mit diesem ersten Material kompatible Material im Wesentlichen aus Silizium bestehen.

10. Verfahren nach einem der Ansprüche 3 bis 8,
**dadurch gekennzeichnet, dass** das erste Material und das zumindest mit diesem ersten Material kompatible Material im Wesentlichen aus Aluminium gebildet sind.

11. Verfahren nach einem der Ansprüche 3 bis 8,
**dadurch gekennzeichnet, dass** das erste Material und das zumindest mit diesem ersten Material kompatible Material im Wesentlichen aus Chrom bestehen.

12. Prägeform für die Nano-Prägelithographie, die mit dem Verfahren nach einem der Ansprüche 1 bis 11 erhalten wird,
wobei diese Prägeform aus einem Träger und aus von diesem Träger getragenen Prägemustern gebildet wird, wobei die Materialien, aus denen dieser Träger und diese Muster bestehen, bei sichtbaren UV-, DUV- bzw. EUV-Strahlungen transparent sind.

13. Prägeform nach Anspruch 12,
**dadurch gekennzeichnet, dass** zumindest bestimmte der Muster bzw. zumindest bestimmte Zwischenräume zwischen benachbarten Mustern eine Abmessung parallel zum Träger haben, die zwischen einigen Nanometern und mehreren Mikrometern liegt.
